# EUROPEAN PATENT APPLICATION

(11) **EP 4 745 726 A1**
(43) Date of publication of application: **20.05.2026**
(21) Application number: 25208561.8
(22) Date of filing: 14.10.2025
(51) Int. Cl.: G06F 3/02, H01H 13/83, H01H 13/705, H01H 3/12, H01H 13/704

(54) **LED KEYBOARD BACKLIGHT MODULE**

(30) Priority: 15.11.2024 CN 202411634763
(71) Applicant: Anhui Hoivway Optoelectronics Technology Co., Ltd, Anqing City, Anhui Province 246400 (CN)
(72) Inventor: FANG, Chengying, Anqing City, 246400 (CN); ZENG, Jiawen, Anqing City, 246400 (CN); HUANG, Xiaowei, Anqing City, 246400 (CN); YANG, Qing, Anqing City, 246400 (CN)
(74) Representative: Valet Patent Services Limited

(57) **Abstract**

The present invention relates to the technical field of keyboard backlight modules, and in particular, to an LED keyboard backlight module, which solves the technical problems of large demand for LED lights, high raw material costs, high power consumption, complex design, and low brightness in conventional keyboard backlight modules. The LED keyboard backlight module comprises a backlight module and a key position module, the backlight module comprises a plurality of light position distribution areas proportionally arranged on an FPC light board, a light emitting module is provided on the light position distribution area to provide backlight for the key position module, and the FPC light board is adhered with an LGP with an upper surface flush with the upper surface of the light emitting module. In the present invention, the quantity of LEDs is decreased from 90-300 in conventional keyboard backlight modules to 10-90, thereby greatly reducing LED costs, greatly improving production efficiency, reducing power consumption, decreasing the quantity of LEDs, improving overall brightness, and simplifying the design difficulty of the entire module.

## Description

### TECHNICAL FIELD

The present invention relates to the technical field of keyboard backlight modules, and in particular, to a light emitting diode (LED) keyboard backlight module.

### BACKGROUND

A backlight keyboard module of a notebook is mainly characterized by illuminated characters on keys, allowing a user to clearly see the characters and work anytime and anywhere at night without turning on a light. Moreover, the keyboard emits soft and comfortable light. In conventional design of keyboard backlight module circuits, a top LED light is usually installed beneath each key. Such a conventional design scheme on the market requires a large quantity of LEDs, and significantly increases power consumption for a notebook battery, resulting in high costs of keyboard modules and greatly shortening the standby time of a computer during work while traveling.

### SUMMARY

In view of the shortcomings of the prior art, the present invention provides an LED keyboard backlight module, which solves the technical problems of large demand for LED lights, high raw material costs, high power consumption, complex design, and low brightness in conventional keyboard backlight modules.

To solve the above technical problems, the present invention provides the following technical solution: An LED keyboard backlight module includes a backlight module and a key position module, the backlight module includes a plurality of light position distribution areas proportionally arranged on a flexible printed circuit (FPC) light board, a light emitting module is provided on the light position distribution area to provide backlight for the key position module, the FPC light board is adhered with a light guide plate (LGP) with an upper surface flush with the upper surface of the light emitting module, light guide dots located below the center of the key position module are provided on the LGP, and the LGP is coated with a light shielding reflective layer that focuses light emitted by the light emitting module and refracts the light onto the light guide dots.

Further, the proportion of the quantity of light positions to the quantity of key caps in the light position distribution area is 1: (2-4).

Further, the light shielding reflective layer is formed by printing with whitening ink for at least 1 to 10 times.

Further, the light emitting module includes an FPC windowing area and an FPC pad arranged on the FPC light board, and the FPC pad is located in the FPC windowing area; the FPC windowing area is printed with a refractive layer that refracts light to all directions; an LED pad is soldered onto the FPC pad, and an LED light set is soldered onto the LED pad; and the upper surface of the LED light set is covered with a reflective layer that reflects light to all directions.

Further, the refractive layer is formed by white ink printed in the FPC windowing area.

Further, the reflective layer is a layer of white reflective material having a thickness of 1 to 50 microns that covers a top light-emitting surface of the LED light set.

Further, the LGP includes an upper area contour near the upper edge of the FPC light board, and an indent area for refracting the light overflowing from the edge is provided near the top row of key caps of the keyboard at the upper area contour.

Further, the key position module includes a hooked iron plate fixed on the backlight module, a key control soft board MEM is assembled on the hooked iron plate, a scissor switch is installed on the key control soft board MEM, and a key cap is detachably connected to the scissor switch.

Further, the light guide dots are distributed in a ratio of 1:1 based on holes on the hooked iron plate.

Through the above technical solution, the LED keyboard backlight module provided by the present invention has at least the following beneficial effects:

1. In the present invention, the packaging method for LEDs, the arrangement of light positions and circuits on the FPC light board, the surface treatment of the light board, the distribution of light guide dots of the LGP, the reflectivity of the light shielding reflective film, and the extraction rate of LED brightness are systematically adjusted to reduce power consumption, reduce the quantity of LEDs, improve overall brightness, and simplify the design difficulty of the entire module.

2. In the present invention, the quantity of LEDs is reduced from 90-300 in conventional keyboard backlight modules to 10-90, thereby greatly reducing LED costs and improving production efficiency; the light source adopts chip scale package (CSP) LED lights, and the small quantity of LEDs has lower power consumption and heat generation and is more conducive to heat dissipation in a computer, thereby improving the overall effective utilization of single-light brightness and prolonging the battery life of the computer.

3. On the premise of increasing the side emission intensity of the LED light set and optimizing the FPC light board, the distribution of light guide dots on the LGP is also optimized, thereby increasing the brightness of the key caps and ultimately achieving the effect of lighting up 2 to 4 key caps by one LED light set 136.

### BRIEF DESCRIPTION OF THE DRAWINGS

The accompanying drawings described here are used for providing a further understanding of this application, and constitute a part of this application. Schematic embodiments of this application and descriptions thereof are used for interpreting this application, rather than constituting improper limitations of this application. In the figures:
FIG. 1 is an exploded structural diagram of a keyboard backlight module in the present invention;
FIG. 2 is a comparison diagram of quantities of light emitting modules on an FPC light board before and after optimization in the present invention;
FIG. 3 is a schematic structural diagram of an FPC light board in the present invention;
FIG. 4 is a schematic structural diagram of a conventional light emitting module in the present invention;
FIG. 5 is a schematic structural diagram of a light emitting module in the present invention;
FIG. 6 is a schematic structural diagram of an LED light set in the present invention;
FIG. 7 is a comparison diagram of an LED light set before and after optimization in the present invention;
FIG. 8 is a schematic diagram of light guide dots in the present invention;
FIG. 9 is a schematic diagram of an outer contour of an LGP in the present invention;
FIG. 10 is a schematic diagram of an LGP before and after optimization in the present invention; and
FIG. 11 is a schematic diagram of power consumption testing in the present invention.

### List of reference numerals:

1. Backlight module; 11. FPC light board; 12. Light position distribution area;
13. Light emitting module; 131. FPC windowing area; 132. Refractive layer; 133. FPC pad; 134. LED pad; 135. LED light set; 136. Reflective layer;
14. LGP; 141. Upper area counter; 142. Indent area;
15. Light guide dot; 16. Light shielding reflective layer;
2. Key position module; 21. Hooked iron plate; 22. Key control software board MEM; 23. Scissor switch; 24. Key cap.

### DETAILED DESCRIPTION

In order to make the above objectives, features, and advantages of the present invention more obvious and understandable, the present invention will be further described in detail below in conjunction with the accompanying drawings and specific embodiments. In this way, the process of applying technical means to solve technical problems and achieve technical effects in this application can be fully understood and implemented.

In a conventional keyboard backlight module, the structure from bottom to surface keys is: an FPC backlight board (featuring a 1:1 arrangement of light positions and key caps, with pads and non-white-ink-covered windows combined with conventional five-side LED lights) → an LGP in the conventional keyboard industry → a light shielding reflective film → a stainless steel keyboard plate → a key control soft board MEM → scissor switches → key caps. However, the conventional keyboard backlight module requires a large quantity of LED lights, and has extremely high power consumption on a notebook battery, resulting in high cost of the keyboard module and greatly shortening the standby time of a computer during work while traveling.

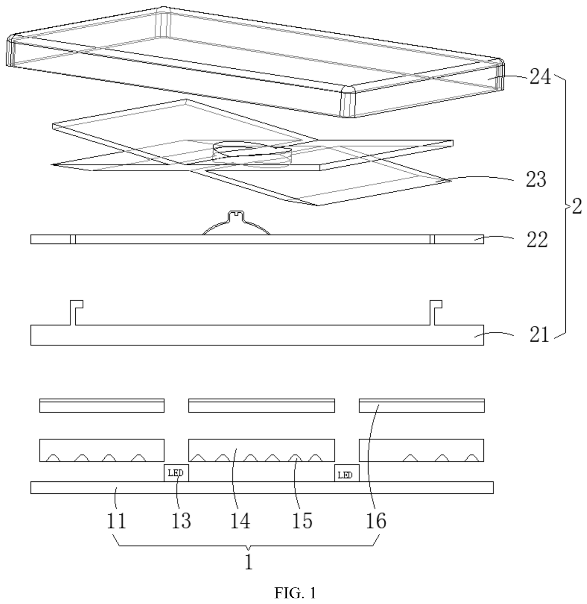

In order to solve the shortcomings of the keyboard backlight module, such as large demand for LED lights, high raw material costs, high power consumption, complex design, and low brightness, with reference to FIG. 1 to FIG. 10, an embodiment proposes an LED keyboard backlight module, where the packaging method for LEDs, the arrangement of light positions and circuits on the FPC light board, the surface treatment of the light board, the distribution of light guide dots of the LGP, the reflectivity of the light shielding reflective film, and the extraction rate of LED brightness are systematically adjusted to reduce power consumption, reduce the quantity of LEDs, improve overall brightness, and simplify the design difficulty of the entire module. The LED keyboard backlight module is composed of a backlight module 1 and a key position module 2, the key position module 2 includes a hooked iron plate 21 fixed on the backlight module 1, a key control soft board MEM 22 is assembled on the hooked iron plate 21, a scissor switch 23 is installed on the key control soft board MEM 22, and a key cap 24 is detachably connected to the scissor switch 23.

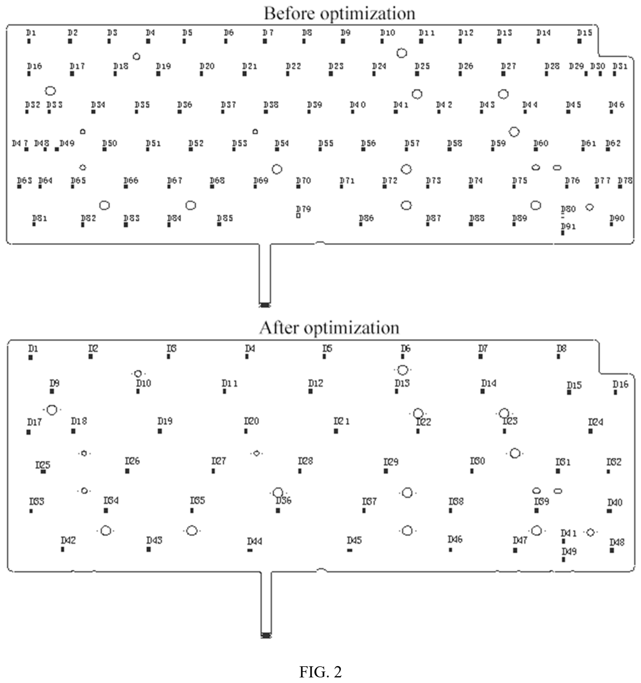

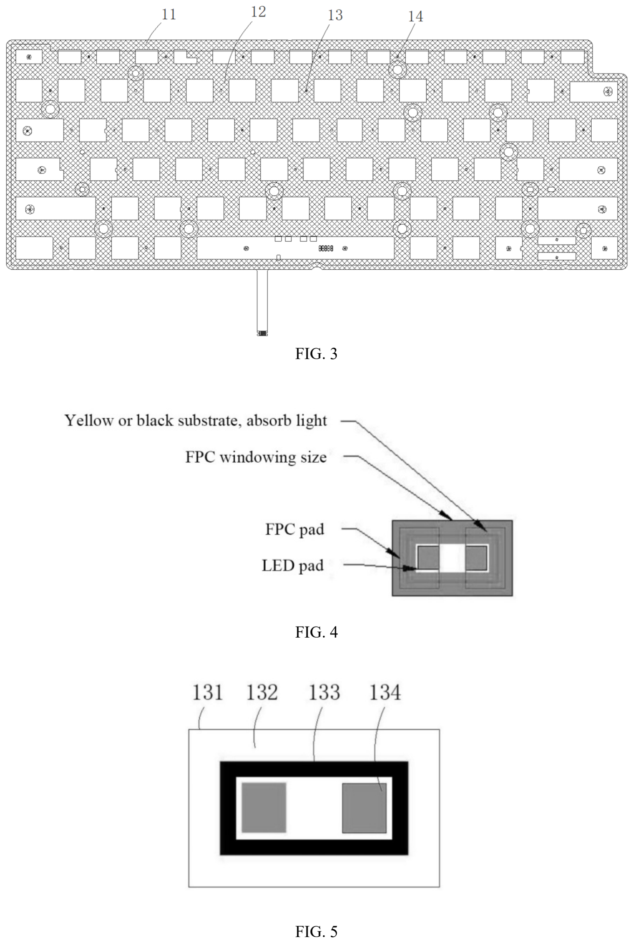

As shown in FIG. 1, the backlight module 1 includes a plurality of light position distribution areas 12 proportionally arranged on an FPC light board 11. The proportion of the quantity of light positions to the quantity of key caps in the light position distribution area 12 is 1: (2-4). A light emitting module 13 is provided on the light position distribution area 12 to provide backlight for the key position module 2. As shown in FIG. 2 and FIG. 3, compared with the existing keyboard backlight module (before optimization), the light position distribution areas 12 proposed in this embodiment are greatly reduced, where original 90-300 PCS LED lights are reduced to 10-90 PCS (after optimization). The conventional module has one LED below each key cap. After improvement, every 2 key caps or 3 to 4 key caps share one LED, and the LED lighted around (360° left, right, up, and down) is placed in the middle of 2 to 4 key caps to reduce the usage quantity of LEDs.

As shown in FIG. 4, the substrate-exposed windowing area of the conventional FPC light board is yellow or black to achieve a light absorption effect. In the present invention, as shown in FIG. 5, the substrate-exposed windowing area of the FPC light board is printed with white ink to improve the refraction of light around the LED, and the actual verification effect shows that the overall brightness of the LED can be effectively improved from original 100% to about 150%. The light emitting module 13 includes an FPC windowing area 131 and an FPC pad 133 arranged on the FPC light board 11, and the FPC pad 133 is located in the FPC windowing area 131. The FPC windowing area 131 is printed with a refractive layer 132 that refracts light to all directions. The refractive layer 132 is formed by white ink printed in the FPC windowing area 131 to achieve a good reflective effect. An LED pad 134 is soldered onto the FPC pad 133, and an LED light set 135 is soldered onto the LED pad 134. The LED light set 135 is a CSP LED light.

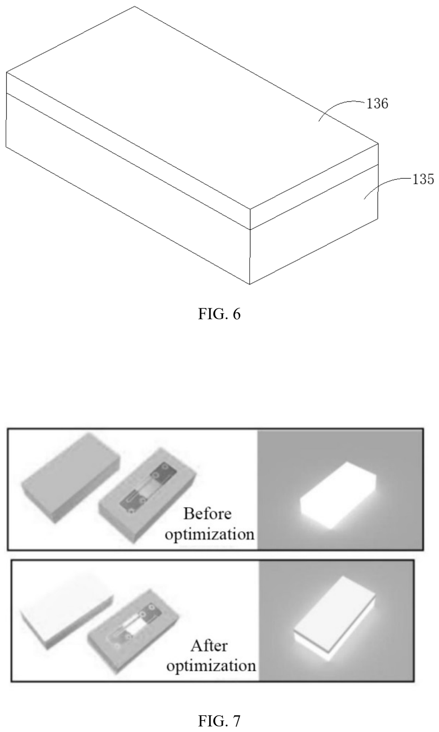

In the conventional structure, one key cap corresponds to one LED, so the LED is designed to emit light on five sides, such as a conventional five-side LED in FIG. 7. In the present invention, 2 to 4 key caps share one LED, so four-side light emission is designed and effective refraction of light is utilized to ensure the brightness of key caps on corresponding two sides. In order to reduce the loss of upper brightness of the conventional LED light, a layer of white reflective material having a thickness of 1 to 50 microns is applied to a top light-emitting surface of the LED through secondary mold processing. As shown in FIG. 6, in the present invention, the upper surface of the LED light set 135 is covered with a reflective layer 136 that reflects light to all directions, and the reflective layer 136 is a layer of white reflective material having a thickness of 1 to 50 microns that covers the top light-emitting surface of the LED light set 135. By changing conventional five-side emission (ordinary top emission) to four-side emission implemented by the reflective layer 136, the side emission intensity of the LED with the same brightness can be effectively increased by 20-80%.

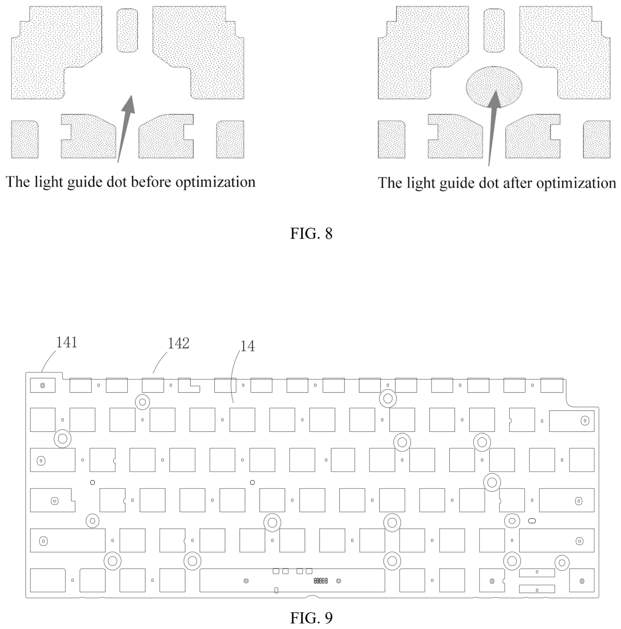

Considering that a plurality of key caps share one LED, on the premise of increasing the side emission intensity of the LED light set 135 and optimizing the FPC light board 11, the distribution of light guide dots 15 on an LGP 14 is also optimized, as shown in FIG. 8, to ultimately achieve the effect of lighting up 2 to 4 key caps by one LED light set 135. Specifically, the FPC light board 11 is adhered with the LGP 14 with an upper surface flush with the upper surface of the light emitting module 13, and the light guide dots 15 located below the center of the key position module 2 are provided on the LGP 14. The light guide dots 15 are distributed in a ratio of 1:1 based on holes on the hooked iron plate 21. The light guide dots 15 function to form spots of light that is emitted by the LED light set 135 and focused and refracted on the light guide dots 15, thereby increasing the brightness of key caps. The light guide dots are arranged based on a program designed by optical software. The program is imported into a high-precision laser machine to apply laser to a mirror material, and the mirror material is printed on an optical film material through a hot pressing process to form a light-emitting LGP, which guides LED light intensity to all directions and effectively refracts light, thereby greatly increasing the brightness of the entire backlight module 1.

The LGP 14 is coated with a light shielding reflective layer 16 that focuses the light emitted by the light emitting module 13 and refracts the light onto the light guide dots 15. The light shielding reflective layer 16 is formed by printing with whitening ink for at least 1 to 10 times. The reflectivity of the white ink is ultimately increased by whitening the white ink for the light shielding reflective layer 16 or by 1 to 10 times of printing, thereby further improving the utilization of light, and enabling the light-reduced backlight module 1 to maintain the comprehensive backlight effect of the conventional module by 50% to 80% of power consumption and 10 to 90 LEDs.

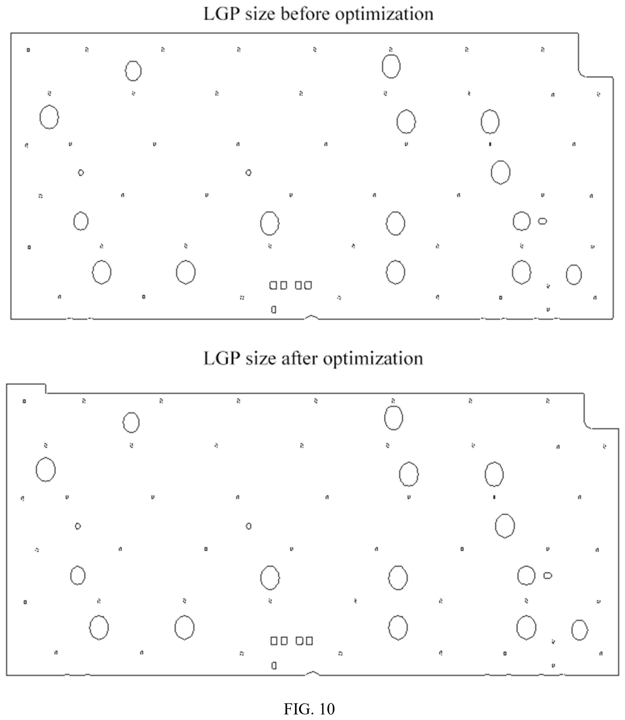

As shown in FIG. 9 and FIG. 10, in order to increase the brightness of a top row of small key caps on ESC and F1 to F12 to achieve uniform backlight of the overall keyboard, the contour of the top area of the LGP 14 is optimized to fully refract the light overflowing from the edge of the LGP to the key caps. Specifically, the LGP 14 includes an upper area contour 141 near the upper edge of the FPC light board 11, and an indent area 142 for refracting the light overflowing from the edge is provided near the top row of key caps of the keyboard at the upper area contour 141.

In the present invention, the brightness of the keyboard backlight module was tested before and after optimization. The test results are shown in Table 1.

**Table 1 Brightness test results**

| Test item | Before optimization | After optimization |
|---|---|---|
| Minimum brightness | 10.85 cd/m² | 14.30 cd/m² |
| Maximum brightness | 32.43 cd/m² | 35.35 cd/m² |
| Darkest key | Key72 | Key42 |
| Brightest key | Key77 | Key75 |
| Unqualified dots | 0 | 0 |
| Average brightness | 16.12 cd/m² | 22.45 cd/m² |
| Brightness consistency | 33.46% | 40.45% |
| Color consistency | 0.0000 | 0.0000 |

From the brightness test results in Table 1, it can be seen that the average brightness of the keyboard backlight module proposed by the present invention was significantly increased compared to the conventional backlight module, with a decrease in the quantity of LEDs from 90-300 to 10-90 and excellent minimum and maximum brightness.

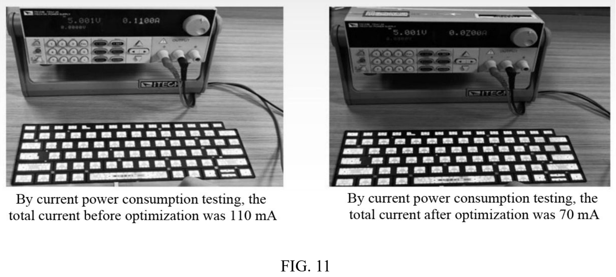

Meanwhile, the power consumption of the keyboard backlight module was also tested before and after optimization. As shown in FIG. 11, through current power consumption testing, the total current before optimization was 110 mA, and the total current after optimization was 70 mA, showing a significant decrease, thereby reducing heat generation of the computer and extending the battery life of the computer.

The various embodiments in this specification are described in a progressive manner, each embodiment focuses on its differences from other embodiments, and the same or similar parts between the various embodiments may be referred to each other. The above embodiments are substantially similar to the method embodiments, and therefore, are described relatively simply. Relevant parts may be referred to the explanations in the method embodiments.

The above embodiments provide a detailed introduction to the present invention, and specific examples are used herein to illustrate the principles and implementations of the present invention. The description of the above embodiments is merely used to help understand the method and core idea of the present invention. Meanwhile, for general technical personnel in the art, the specific implementations and the application scope may be modified according to the idea of the present invention. In summary, the content of this specification should not be understood as limiting the present invention.

## Claims

1. An LED keyboard backlight module, comprising a backlight module (1) and a key position module (2), wherein the backlight module (1) comprises a plurality of light position distribution areas (12) proportionally arranged on an FPC light board (11), a light emitting module (13) is provided on the light position distribution area (12) to provide backlight for the key position module (2), the FPC light board (11) is adhered with an LGP (14) with an upper surface flush with the upper surface of the light emitting module (13), light guide dots (15) located below the center of the key position module (2) are provided on the LGP (14), and the LGP (14) is coated with a light shielding reflective layer (16) that focuses light emitted by the light emitting module (13) and refracts the light onto the light guide dots (15).

2. The LED keyboard backlight module according to claim 1, wherein the proportion of the quantity of light positions to the quantity of key caps in the light position distribution area (12) is 1: (2-4).

3. The LED keyboard backlight module according to claim 1, wherein the light shielding reflective layer (16) is formed by printing with whitening ink for at least 1 to 10 times.

4. The LED keyboard backlight module according to claim 1, wherein the light emitting module (13) comprises an FPC windowing area (131) and an FPC pad (133) arranged on the FPC light board (11), and the FPC pad (133) is located in the FPC windowing area (131); the FPC windowing area (131) is printed with a refractive layer (132) that refracts light to all directions; an LED pad (134) is soldered onto the FPC pad (133), and an LED light set (135) is soldered onto the LED pad (134); and the upper surface of the LED light set (135) is covered with a reflective layer (136) that reflects light to all directions.

5. The LED keyboard backlight module according to claim 4, wherein the refractive layer (132) is formed by white ink printed in the FPC windowing area (131).

6. The LED keyboard backlight module according to claim 4, wherein the reflective layer (136) is a layer of white reflective material having a thickness of 1 to 50 microns that covers a top light-emitting surface of the LED light set (135).

7. The LED keyboard backlight module according to claim 1, wherein the LGP (14) comprises an upper area contour (141) near the upper edge of the FPC light board (11), and an indent area (142) for refracting the light overflowing from the edge is provided near the top row of key caps of the keyboard at the upper area contour (141).

8. The LED keyboard backlight module according to claim 1, wherein the key position module (2) comprises a hooked iron plate (21) fixed on the backlight module (1), a key control soft board MEM (22) is assembled on the hooked iron plate (21), a scissor switch (23) is installed on the key control soft board MEM (22), and a key cap (24) is detachably connected to the scissor switch (23).

9. The LED keyboard backlight module according to claim 8, wherein the light guide dots (15) are distributed in a ratio of 1:1 based on holes on the hooked iron plate (21).
